# EUROPÄISCHE PATENTSCHRIFT

(11) **EP 1 330 947 B1**
(45) Veröffentlichungstag und Bekanntmachung des Hinweises auf die Patenterteilung: **24.01.2007**
(21) Anmeldenummer: 01993140.1
(22) Anmeldetag: 01.11.2001
(51) Int. Cl.: H05K 7/14, H05K 1/02

(54) **FÜR EIN KRAFTFAHRZEUG BESTIMMTES ELEKTRONISCHES GERÄT**
ELECTRONIC DEVICE FOR A MOTOR VEHICLE
APPAREIL ELECTRONIQUE DESTINE A UN VEHICULE

(30) Priorität: 03.11.2000 DE 10054588
(43) Veröffentlichungstag der Anmeldung: 30.07.2003
(73) Patentinhaber: SIEMENS AKTIENGESELLSCHAFT, 80333 München (DE)
(72) Erfinder: HOFMANN, Georg, 35580 Wetzlar (DE)
(86) Internationale Anmeldenummer: PCT/DE2001/004093
(87) Internationale Veröffentlichungsnummer: WO 2002/037915

(56) Entgegenhaltungen:
- DE-A- 4 325 499
- DE-U- 7 820 391
- DE-U- 29 815 003

## Beschreibung

Die Erfindung betrifft ein für ein Kraftfahrzeug bestimmtes elektronisches Gerät, beispielsweise ein Autoradio, ein Bordcomputer oder eine Fahrzeugnavigation, welches in einem Gehäuse eine Leiterplatte mit zumindest einem darauf gehaltenen Bedienteil hat, das aus einer Frontplatte des Gehäuses herausragt.

Bei Geräten der vorstehenden Art besteht das Problem, dass sich Insassen des Kraftfahrzeugs an vorspringenden Bedienteilen verletzen können, wenn sie beispielsweise mit dem Kopf oder Knie gegen ein solches Bedienteil prallen. Deshalb werden solche Bedienteile oftmals aus einem weichen Kunststoff gefertigt, so dass sie bei auf sie einwirkenden Stößen elastisch nachgeben können. Bei elektrischen Zigarettenanzündern ist es auch schon bekannt, diese so anzuordnen, dass sie bei Nichtgebrauch nicht aus der Kontur einer sie aufnehmenden Fläche ragen. Erst nach Hineindrücken des Zigarettenanzünders in die Kontur der Fläche springt dieser mit einem Griffteil aus der Kontour heraus, so dass er dann ergriffen werden kann.

Bei elektronischen Geräten sind versenkbare Bedienteile, die erst zum Zwecke des Gebrauchs in eine vorspringende Gebrauchslage gelangen, schon allein aus Kostengründen nicht akzeptabel. Weiterhin wäre es bei solchen verschieblichen Bedienteilen nachteilig, dass diese immer erst bedient werden können, wenn man sie zuvor durch eine kurzfristige, axiale Druckkraft zum Herausfahren aus dem Gerät betätigt hat, was vor allem bei häufig benutzten

Bedienteilen lästig wäre und dazu führen könnte, dass sie nach Benutzung aus Bequemlichkeit nicht in die versenkte Position bewegt werden, so dass der Sicherheitsgewinn verloren ginge. Während der Bedienphase bestünde die Gefahr einer Verletzung an einem solchen Bedienteil, wenn gerade dann ein Unfall erfolgt.

Der Erfindung liegt das Problem zugrunde, ein elektronisches Gerät der eingangs genannten Art so zu gestalten, dass seine Bedienteile ohne vorherige Manipulation stets zur Benutzung zur Verfügung stehen, jedoch durch möglichst einfache Mittel so ausgebildet sind, dass sie im Falle eines Unfalls kein Verletzungsrisiko darstellen.

Dieses Problem wird erfindungsgemäß dadurch gelöst, dass die Leiterplatte zum Eintauchen des Bedienteils in das Gerät bei Überschreiten einer auf das Bedienteil wirkenden Kraft in das Geräteinnere hinein verschieblich in dem Gerät befestigt ist.

Durch diese Gestaltung kann man die Bedienteile genau wie bei Geräten ohne die Versenkbarkeit der Bedienteile ausbilden und deshalb handelsübliche Bedienteile verwenden. Da nicht mehr für jedes einzelne Bedienteil Mittel zur Herbeiführung der Versenkbarkeit vorgesehen werden müssen, sondern die gesamte Leiterplatte bei einem Aufprall auf ein Bedienteil ausweicht, erhöhen sich die Kosten für die Versenkbarkeit der Bedienteile nicht durch die Anzahl der Bedienteile.

Die erfindungsgemäße Verschiebbarkeit der Leiterplatte kann auf sehr unterschiedliche Weise verwirklicht werden. Man könnte beispielsweise daran denken, diese durch Federkräfte gegen bedienseitige Anschläge vorzuspannen. Besonders einfach lässt sich die Verschiebbarkeit erreichen, wenn hierzu die Leiterplatte über Sollbruchstellen mit dem Gehäuse verbunden ist.

Auch die Sollbruchstellen können auf verschiedene Weise und an verschiedenen Bauteilen - beispielsweise an Befestigungsschrauben der Leiterplatte - vorgesehen werden. Zur weiteren Verringerung der Kosten trägt es bei, wenn gemäß einer anderen Weiterbildung der Erfindung die Sollbruchstellen durch ausbrechbare Bereiche der Leiterplatte gebildet sind. Hierdurch ist es auf besonders einfache Weise möglich, die Ausbrechkräfte den jeweiligen Erfordernissen anzupassen.

Fertigungstechnisch besonders günstig ist das elektronisches Gerät gestaltet, wenn die Leiterplatte mittels Schrauben mit dem Gehäuse verbunden ist, welche jeweils durch ein Loch der Leiterplatte führen, und wenn die ausbrechbaren Bereiche durch Ausfräsungen der Leiterplatte gebildet sind, welche das jeweilige Loch umgeben. Bei einer solchen Ausführungsform kann man übliche Leiterplatten verwenden und lediglich im Bereich der Löcher für ihre Befestigung nachträglich die Ausfräsungen vorsehen.

Beim Festschrauben der jeweiligen Leiterplatte werden durch die jeweiligen Schrauben beträchtliche Verdrehkräfte in die Leiterplatte eingeleitet, welche bei den Sollbruchstellen dazu führen können, dass diese ausbrechen, wenn sie nicht gegenüber solchen Verdrehkräften ausreichend fest gestaltet sind. Eine Erhöhung der Festigkeit gegen Verdrehkräfte der Sollbruchstellen führt normalerweise jedoch zugleich dazu, dass die Sollbruchstellen auch in Axialrichtung eine erhöhte Festigkeit erhalten, so dass die Bedienelemente erst bei unerwünscht hohen Kräften auszuweichen vermögen. Eine für die Schraubbefestigung ausreichend hohe Festigkeit gegen Verdrehkräfte und geringe Festigkeit bei Einwirkung von Axialkräften auf die Bedienteile lässt sich mit einfachen Mitteln erreichen, wenn jeweils zwei bogenförmig und koaxial zu jedem Loch verlaufende Ausfräsungen vorgesehen sind und die ausbrechbaren Bereiche sich jeweils zwischen den Enden dieser Ausfräsungen befinden. Die bogenförmigen Ausfräsungen ermöglichen es zusätzlich - indem sie über einen mehr oder weniger großen Winkelbereich verlaufen - die Breite der ausbrechbaren Bereiche zu verändern und dadurch die Ausbrechkraft den jeweiligen Bedürfnissen entsprechend festzulegen.

Konstruktiv besonders einfach ist das elektronische Gerät gestaltet, wenn die Leiterplatte durch die Schrauben an der Frontplatte befestigt ist.

Ganz besonders günstig ist es, wenn die ausbrechbaren Bereiche an unterschiedlichen Befestigungsstellen unterschiedlichen Querschnitt aufweisen. Hierdurch kann man bei der Festlegung der Ausbrechkraft die Position der Bedienteile auf der Leiterplatte und damit relativ zu den Sollbruchstellen berücksichtigen. Wünscht man beispielsweise, dass alle Sollbruchstellen gleichzeitig ausbrechen und befindet sich ein Bedienteil nahe einer Sollbruchstelle, so kann man diese Sollbruchstelle relativ fest und die übrigen Sollbruchstelle entsprechend des größeren Abstandes von dem Bedienteil entsprechend schwächer ausbilden, also die jeweiligen Hebelarme für die Krafteinwirkung berücksichtigen.

Die Erfindung lässt verschiedene Ausführungsformen zu. Zur weiteren Verdeutlichung ihres Grundprinzips ist eine davon in der Zeichnung dargestellt und wird nachfolgend beschrieben. Diese zeigt in
- Fig.1: einen schematischen Querschnitt durch ein elektronisches Gerät nach der Erfindung,
- Fig.2: eine Draufsicht auf einen Befestigungsbereich der Leiterplatte,
- Fig.3: eine perspektivische Ansicht auf einen Befestigungsbereich einer Leiterplatte des Gerätes.

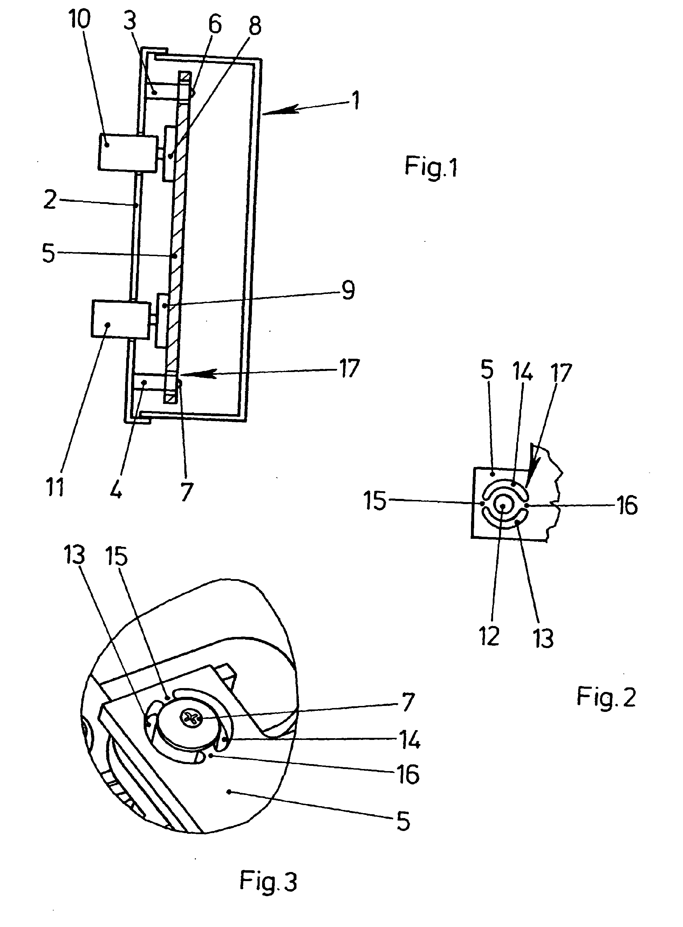

Das in Figur 1 gezeigte elektronische Gerät hat ein Gehäuse 1, welches an seiner Vorderseite eine Frontplatte 2 aufweist. Von der Frontplatte 2 ragen Ansätze 3, 4 nach innen, auf denen sich eine Leiterplatte 5 abstützt, die durch Schrauben 6, 7 auf diesen Ansätze 3, 4 gehalten ist. Auf der Leiterplatte 5 sind zwei Stellelemente 8, 9 angeordnet, welche jeweils ein als Drehknopf ausgebildetes Bedienteil 10, 11 aufweisen. Diese Bedienteile 10, 11 ragen so weit aus der Frontplatte 2 heraus, dass man sie bequem greifen und verdrehen kann. Bei den Bedienteilen 10, 11 kann es sich auch um durch Drucktasten betätigbare Bedienteile handeln.

Wichtig für die Erfindung ist, dass die Leiterplatte 5 sich bei hohen axialen Kräften auf zumindest einem der Bedienteile 10, 11, wie sie beispielsweise bei einem

Kopfaufprall eines Fahrzeuginsassen auf die Bedienteile 10, 11 auftreten können, von den Ansätzen 3, 4 lösen und weiter in das Innere des Gehäuses 1 hinein bewegen kann. Hierzu sind in den folgenden Figuren näher gezeigte Sollbruchstellen 17 in der Leiterplatte 5 vorgesehen. Durch diese Verschiebbarkeit der Leiterplatte 5 vermögen die Bedienteile 10, 11 sich vollständig in das Gehäuse 1 hinein zu bewegen, so dass sie dann nicht mehr aus der Frontplatte 2 herausragen.

Die Figur 2 zeigt einen Befestigungsbereich der Leiterplatte 5. Zu erkennen ist ein Loch 12, durch welches die in Figur 1 zu sehende Schraube 6 oder 7 geführt werden kann. Dieses Loch 12 ist von zwei bogenförmigen Ausfräsungen 13, 14 umgeben, zwischen deren Enden jeweils ein relativ schmaler, ausbrechbarer Bereich 15, 16 der Leiterplatte verbleibt. Über diese Bereiche 15, 16 müssen die über die Bedienteile 10, 11 in die Leiterplatte 5 eingeleiteten Kräfte jeweils auf die Schrauben 6, 7 übertragen werden. Übersteigen diese Kräfte die Festigkeit der Bereiche 15, 16, dann brechen diese, so dass die Leiterplatte 5 von den in Figur 1 gezeigten Ansätzen 3, 4 frei kommt und sich damit die Leiterplatte 5 in das Innere das Gehäuses 1 hinein bewegen kann. Die Ausfräsungen 13, 14 erzeugen somit die Sollbruchstelle 17.

Die Figur 2 zeigt perspektivisch einen Randbereich der Leiterplatte 5 mit den beiden Ausfräsungen 13, 14 und den ausbrechbaren Bereichen 15, 16 sowie die Schraube 7. Zu erkennen ist, dass die Leiterplatte 5 sich zu lösen vermag, wenn die ausbrechbaren Bereiche 15, 16 ausbrechen.

## Patentansprüche

1. Für ein Kraftfahrzeug bestimmtes elektronisches Gerät, beispielsweise ein Autoradio, ein Bordcomputer oder eine Fahrzeugnavigation, welches in einem Gehäuse eine Leiterplatte mit zumindest einem darauf gehaltenen Bedienteil hat, das aus einer Frontplatte des Gehäuses herausragt, **dadurch gekennzeichnet, dass** die Leiterplatte (5) zum Eintauchen des Bedienteils (10, 11) in das Gerät bei Überschreiten einer auf das Bedienteil (10, 11) wirkenden Kraft in das Geräteinnere hinein verschieblich in dem Gerät befestigt ist.

2. Elektronisches Gerät nach Anspruch 1, **dadurch gekennzeichnet, dass** zur Ermöglichung der Verschiebbarkeit der Leiterplatte (5) diese über Sollbruchstellen (17) mit dem Gehäuse (1) verbunden ist.

3. Elektronisches Gerät nach Anspruch 2, **dadurch gekennzeichnet, dass** die Sollbruchstellen (17) durch ausbrechbare Bereiche (15, 16) der Leiterplatte (5) gebildet sind.

4. Elektronisches Gerät nach zumindest einem der vorangehenden Ansprüche, **dadurch gekennzeichnet, dass** die Leiterplatte (5) mittels Schrauben (6, 7) mit dem Gehäuse (1) verbunden ist, welche jeweils durch ein Loch (12) der Leiterplatte (5) führen, und dass die ausbrechbaren Bereiche (15, 16) durch Ausfräsungen (13, 14) der Leiterplatte (5) gebildet sind, welche das jeweilige Loch (12) umgeben.

5. Elektronisches Gerät nach Anspruch 4, **dadurch gekennzeichnet, dass** jeweils zwei bogenförmig und koaxial zu jedem Loch (12) verlaufende Ausfräsungen (13, 14) vorgesehen sind und die ausbrechbaren Bereiche (15, 16) sich jeweils zwischen den Enden dieser Ausfräsungen (13, 14) befinden.

6. Elektronisches Gerät nach zumindest einem der vorangehenden Ansprüche, **dadurch gekennzeichnet, dass** die Leiterplatte (5) durch die Schrauben (6, 7) an der Frontplatte (2) befestigt ist.

7. Elektronisches Gerät nach zumindest einem der vorangehenden Ansprüche, **dadurch gekennzeichnet, dass** die ausbrechbaren Bereiche (15, 16) an unterschiedlichen Befestigungsstellen unterschiedlichen Querschnitt aufweisen.

## Claims

1. Electronic device for a motor vehicle, for example a car radio, an on-board computer or a vehicle navigation system, which, in a housing, has a printed circuit board having at least one control element mounted thereon, said control element protruding out of a front panel of the housing, **characterized in that** the printed circuit board (5) is fastened in the device such that it can be displaced into the interior of the device, so that the control element (10, 11) can dip into the device, when a force acting on the control element (10, 11) is exceeded.

2. Electronic device according to Claim 1, **characterized in that**, in order to allow the printed circuit board (5) to be displaceable, said printed circuit board (5) is connected to the housing (1) by means of predetermined breaking points (17).

3. Electronic device according to Claim 2, **characterized in that** the predetermined breaking points (17) are formed by breakaway regions (15, 16) of the printed circuit board (5).

4. Electronic device according to at least one of the preceding Claims, **characterized in that** the printed circuit board (5) is connected to the housing (1) by means of screws (6, 7) which in each case extend through a hole (12) in the printed circuit board (5), and **in that** the breakaway regions (15, 16) are formed by milled-out portions (13, 14), which surround the respective hole (12), in the printed circuit board (5).

5. Electronic device according to Claim 4, **characterized in that** in each case two arcuate milled-out portions (13, 14) which run coaxially with respect to each hole (12) are provided, and the breakaway regions (15, 16) are situated in each case between the ends of said milled-out portions (13, 14).

6. Electronic device according to at least one of the preceding claims, **characterized in that** the printed circuit board (5) is fastened to the front panel (2) by means of the screws (6, 7).

7. Electronic device according to at least one of the preceding claims, **characterized in that** the breakaway regions (15, 16) have a different cross section at different fastening points.

## Revendications

1. Appareil électronique destiné à un véhicule automobile, par exemple, un poste autoradio, un ordinateur de bord ou un appareil de navigation pour véhicules, qui comporte, dans un boîtier, une carte à circuits imprimés avec au moins un organe de commande maintenu sur ladite platine et qui fait saillie hors d'un panneau avant du boîtier, **caractérisé par le fait que** la carte à circuits imprimés (5) est fixée dans l'appareil de telle façon qu'elle peut s'enfoncer à l'intérieur de l'appareil pour escamoter l'organe de commande (10, 11) dans l'appareil, lorsqu'une force agissant sur l'organe de commande (10, 11) est dépassée.

2. Appareil électronique selon la revendication 1, **caractérisé par le fait que**, pour permettre l'escamotage de la carte à circuits imprimés (5), celle-ci est liée au boîtier (1) par l'intermédiaire de points de rupture (17).

3. Appareil électronique selon la revendication 2, **caractérisé par le fait que** les points de rupture (17) sont formés par des zones de rupture (15, 16) sur la carte à circuits imprimés (5).

4. Appareil électronique selon au moins l'une des revendications précédentes, **caractérisé par le fait que** la carte à circuits imprimés (5) est fixée au boîtier (1) au moyen de vis (6, 7) qui passent chacune à travers un trou (12) de la carte à circuits imprimés (5) et que les zones de rupture (15, 16) sont formées par des fraisages (13, 14) dans la carte à circuits imprimés (5) qui entourent le trou respectif (12).

5. Appareil électronique selon la revendication 4, **caractérisé par le fait qu'**il est prévu, dans chaque cas, deux fraisages (13, 14) en forme d'arc, coaxiaux par rapport à chaque trou (12), et que les zones de rupture (15, 16) se trouvent chacune entre les extrémités de ces fraisages (13, 14).

6. Appareil électronique selon au moins l'une des revendications précédentes, **caractérisé par le fait que** la carte à circuits imprimés (5) est fixée sur le panneau avant (2) par les vis (6, 7).

7. Appareil électronique selon au moins l'une des revendications précédentes, **caractérisé par le fait que** les zones de rupture (15, 16) ont des sections transversales différentes à différents points de fixation.
